# EUROPÄISCHE PATENTSCHRIFT

(11) **EP 1 309 998 B1**
(45) Veröffentlichungstag und Bekanntmachung des Hinweises auf die Patenterteilung: **21.10.2009**
(21) Anmeldenummer: 01956356.8
(22) Anmeldetag: 20.07.2001
(51) Int. Cl.: H01L 23/495, H01L 23/538, H01L 23/13, H01L 21/48

(54) **VERFAHREN ZUR ELEKTRISCHEN VERBINDUNG EINES HALBLEITERBAUELEMENTS MIT EINER ELEKTRISCHEN BAUGRUPPE**
METHOD FOR ELECTRICALLY CONNECTING A SEMICONDUCTOR COMPONENT TO AN ELECTRICAL SUBASSEMBLY
PROCEDE DE CONNEXION ELECTRIQUE D'UN COMPOSANT SEMI-CONDUCTEUR ET D'UN ASSEMBLAGE ELECTRIQUE

(30) Priorität: 04.08.2000 DE 10038092
(43) Veröffentlichungstag der Anmeldung: 14.05.2003
(73) Patentinhaber: ROBERT BOSCH GMBH, 70442 Stuttgart (DE)
(72) Erfinder: TOPP, Rainer, 72768 Reutlingen (DE); BALSZUNAT, Dirk, 72072 Tuebingen (DE); ERNST, Stephan, 73760 Ostfildern (DE); HENKEL, Achim, 72766 Reutlingen (DE); EIMERS-KLOSE, Doerte, 72762 Reutlingen (DE); MILICH, Reinhard, 72770 Reutlingen (DE)
(86) Internationale Anmeldenummer: PCT/DE2001/002755
(87) Internationale Veröffentlichungsnummer: WO 2002/013269

(56) Entgegenhaltungen:
- DE-A- 3 916 899
- US-A- 4 604 678
- US-A- 4 967 261
- US-A- 5 669 137
- US-A- 5 789 280
- PATENT ABSTRACTS OF JAPAN vol. 1999, no. 14, 22. Dezember 1999 (1999-12-22) -& JP 11 265956 A (HEWLETT PACKARD CO <HP>), 28. September 1999 (1999-09-28)

## Beschreibung

### Stand der Technik

Die Erfindung geht aus von einem Verfahren nach der Gattung des Hauptanspruchs. Es ist schon ein solches Verfahren aus der US 3 922 712 bekannt, bei der jedoch ein zunächst unzerteiltes Stanzgitter auf einen Halbleiterchip aufgebracht wird, um ein diskretes, mit Kontaktbeinen versehenes und gehäustes Halbleiterbauelement zu erhalten, das in späteren Schritten mit anderen Schaltungsbestandteilen verlötet werden kann.

Aus der US-A-4,967,261 sind Verfahren zur elektrischen Verbindung eines Halbleiterbauelements mit einer elektrischen Baugruppe bekannt, bei dem die Halbleiterbauelementanschlüsse sowie Metallstreifengitter mit inneren bzw. äußeren Anschlussenden aus leitfähigem Material sind. Sie werden mit Hilfe eines Kontaktrahmens aus elektrisch nicht leitfähigem Material fixiert. Die gesamte Anordnung ermöglicht eine mechanische Befestigung, die auch eine elektrische Verbindung zwischen den elektrischen Anschlüssen des Halbleiterbauelements und der elektrischen Baugruppe herstellt.

Aus der DE-A-39 16899 ist ein Verfahren zur elektrischen Verbindung eines Halbleiterbauelements mit einer elektrischen Baugruppe bekannt, bei dem das Bauelement auf einem Kühlkörper in einem Gehäuse untergebracht wird. Aus der US-A-5,669,137 ist ein ähnliches. Verfahren bekannt, bei dem als Halbleiterbauelement ein SMD-Bauelement verwendet wird und aus der US-A-4,604,678 sind weitere Verfahren zur elektrischen Verbindung eines Halbleiterbauelements mit einer elektrischen Baugruppe bekannt, die eine hohe Packungsdichte der Halbleiterelemente ermöglichen.

### Vorteile der Erfindung

Das erfindungsgemäße Verfahren mit den kennzeichnenden Merkmalen des Hauptanspruchs hat demgegenüber den Vorteil, unter Einsatz möglichst weniger Verbindungstechniken und möglichst weniger Verfahrensschritte, ohne Verwendung von Bonddrähten, insbesondere Halbleiter-Leistungsbauelemente mit weiteren Teilen einer elektrischen Baugruppe zu kontaktieren, die insbesondere in widrigen Umgebungen wie dem Motorraum eines Kraftfahrzeugs eingesetzt werden kann. Ein drahtbondloses Kontaktieren ermöglicht ein platzsparendes Kontaktieren, da keine Verfahrwege für den Kopf eines Bonders vorgesehen werden müssen. Außerdem wird im Vergleich zu Bondverbindungen eine mechanisch robustere elektrische Verbindung erzielt. Es ist nicht mehr notwendig, für Hochleistungsanwendungen separate sogenannte Leistungsbausteine herzustellen, das sind Kombinationen von Kupferelementen mit Halbleiterchips, die wiederum auf einen Kühlkörper aufgeklebt werden, der in dem Gehäuse der elektrischen Baugruppe integriert ist (siehe zum Beispiel das aus der EP 98928076 bekannte Vorgehen). Die Oberflächenqualität verwendeter Metallkörper muß nicht mehr so hoch sein, daß darauf gebondet werden kann.

Durch die in den abhängigen Ansprüchen aufgeführten Maßnahmen sind vorteilhafte Weiterbildungen und Verbesserugen des im Hauptanspruch angegebenen Verfahrens möglich.

Besonders vorteilhaft ist es, ein zumindest teilweise beidseitig, insbesondere in Form eines Kontaktrahmens, von elektrisch nicht leitfähigen Material umgebenes Stanzgitter zu verwenden, da so das nachfolgend direkt mit dem Halbleiterchip in elektrischer Verbindung stehende Leitergitter sich selbst trägt und einfach gehandhabt werden kann. Dabei ermöglicht es im montierten Zustand die Stapelung mit weiteren über Kontaktrahmen verbundene Stanzgitter, die ihrerseits weitere Chips kontaktieren, da durch die zumindest teilweise beidseitige Umbettung der einzelnen Stanzgitter eine elektrische Isolation voneinander nicht nur zwischen den Stanzgitterleiterbahnen einer Ebene, sondern auch zwischen den Stanzgitterleiterbahnen aufeinandergestapelter Kontaktrahmen gewährleistet wird.

Besonders vorteilhaft ist außerdem die Verwendung eines Stanzgitters beziehungsweise eines Metallstreifengitters, das so strukturiert ist, daß eine der Leiterbahnen mit der Unterseite des Chips zumindest in thermisch leitender Weise verbunden werden kann. Dadurch entfallen separat vorzusehende Kühlkörper.

Vorteilhaft ist darüber hinaus durch die Verwendung eines über einen elektrisch nicht leitenden Kontaktrahmen verbundenen Stanzgitters die sich eröffnende Möglichkeit der Parallelität der Prozessführung: in einem Verfahrensschritt kann die endgültige elektrische und/oder thermisch leitende Verbindung sowohl mit der Unterseite als auch mit den metallisierten Kontaktbereichen auf der Oberseite des Chips hergestellt werden. Dadurch wird letztlich in einem Verbindungsschritt sowohl die Anbindung an die Wärmesenke als auch zu den äußeren Steckern und Anschlußelementen der elektrischen Baugruppe erzeugt.

Weitere Vorteile ergeben sich aus den weiteren in den Unteransprüchen und in der Beschreibung genannten Merkmalen.

### Zeichnung

Ausführungsbeispiele der Erfindung sind in der Zeichnung dargestellt und in der nachfolgenden Beschreibung näher erläutert. Es zeigen Figur 1 eine Draufsicht, Figur 2 eine zweite Draufsicht, Figur 3 einen Teilquerschnitt, und Figur 4 einen weiteren Teilquerschnitt. Figur 5 zeigt eine Draufsicht verschiedener Verfahrensweisen zur Herstellung einer elektrischen Verbindung eines Halbleiterbauelements mit weiteren Teilen einer elektrischen Baugruppe die nicht Teil der Erfindung sind, und Figur 6 illustriert die Verwendung eines IMS-Substrats.

### Beschreibung der Ausführungsbeispiele

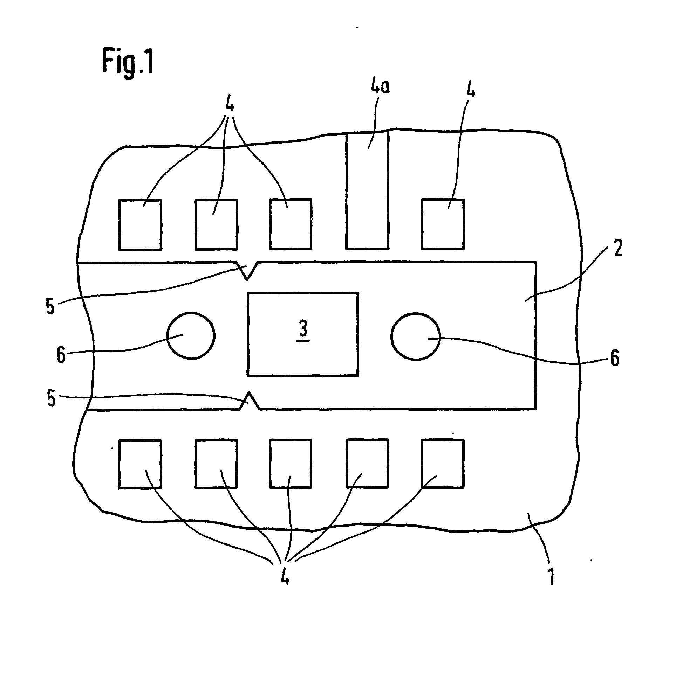

Figur 1 zeigt eine Draufsicht auf dem aus elektrisch nicht-leitenden Material bestehenden Gehäuseboden 1 einer elektrischen Baugruppe. In den Gehäuseboden sind bereits Anschlußbereiche 4 sowie Leiterbahn-Anschlußbereiche 4a eingebracht, vorzugsweise in Form von Stanzgitterleiterbahnen beziehungsweise Metallstreifen oder -quadraten, die in eine noch weiche, da noch heisse Grundform des Gehäusebodens eingepresst wurden und nunmehr in in dem vorzugsweise aus Kunststoff bestehenden Gehäuseboden eingebetteter Form vorliegen. Zunächst wird ein als Wärmesenke 2 dienender metallischer Körper in den Gehäuseboden eingeklebt beziehungsweise eingelegt. Die Wärmesenke weist zwei Öffnungen 6 auf, durch die hindurch der Gehäuseboden 1 sichtbar bleibt. Ferner weist die Wärmesenke 2 zwei als Justiermarken 5 dienende Einkerbungen auf. Diese dienen nachfolgend zur Justage bei der Anordnung des ungehäusten Halbleiterchips 3 auf der Wärmesenke. Vor dem Aufbringen des Chips wird dieser mit einem elektrisch leitfähigen Verbindungsmaterial belegt, so daß im weiteren Verbindungsprozess neben der Wärmeableitung eine elektrische Kontaktierung des Chipbodens über die Wärmesenke ermöglicht wird. Als Verbindungsmaterial kann hierbei ein elektrisch leitender Klebstoff oder Lot verwendet werden.

Die Anschlußbereiche sollen dazu dienen, ein im Folgenden mit diesen Anschlußbereichen elektrisch zu kontaktierendes Halbleiterbauelement mit weiteren, nicht näher dargestellten Teilen der elektrischen Baugruppe zu verbinden. Diese weiteren Teile der elektrischen Baugruppe können aus weiteren diskreten Halbleiterbauelementen oder monolithischen Schaltungsgruppen bestehen. Es ist auch möglich, den Leiterbahn-Anschlußbereich 4a beziehungsweise mehrere Leiterbahn-Anschlußbereiche in der Form des Leiterbahn-Anschlußbereichs 4a so auszubilden, daß daß der Stanzgitter-Metallstreifen an seinem nicht dargestellten Ende direkt als starre, aus dem Gehäusenboden hinausragende Steckverbindung dient, über die die elektrische Baugruppe als Ganzes in ein weibliches Anschlußelement eines separaten Aufbaus eingesteckt werden kann. Hat der Metallstreifen 4a an seinem nicht dargestellten, aus dem Gehäuseboden herausragende Ende ein Loch, so kann über dieses Loch alternativ die elektrische Baugruppe über eine Schraubkontaktierung an den elektrischen Anschlüssen eines separaten Aufbaus befestigt werden.

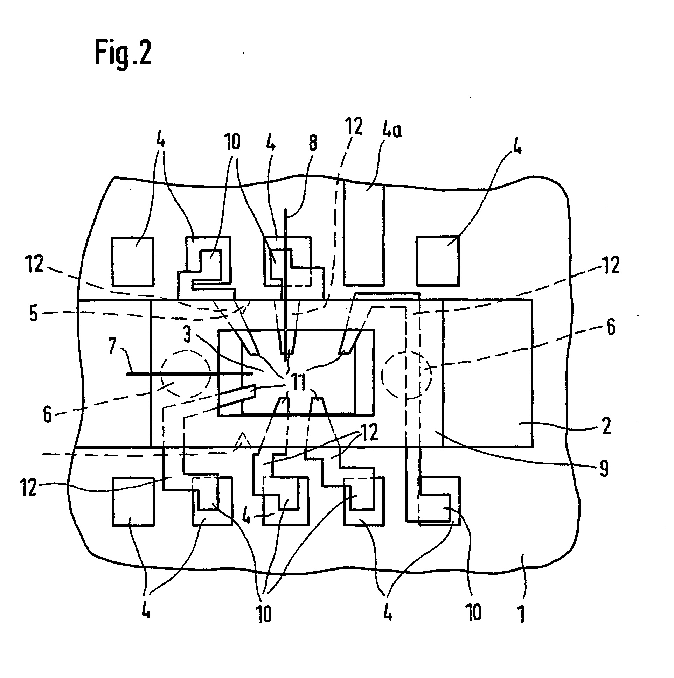

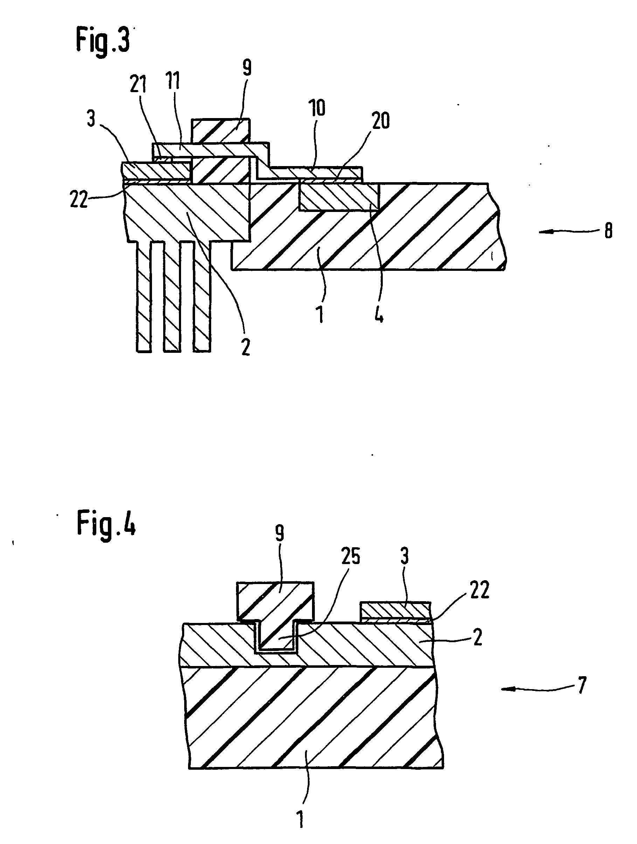

Im Anschluß an die Fixierung des Halbleiterchips auf der Wärmesenke wird, wie in Figur 2 dargestellt, ein Kontaktrahmen 9 aufgebracht. Der aus elektrisch nichtleitendem Material bestehende Kontaktrahmen umschließt Stanzleiterbahnen 12, die äußere Anschlußenden 10 sowie inneren Anschlußenden 11 aufweisen. Der Kontaktrahmen verbindet die Stanzleiterbahnen mechanisch miteinander und fixiert sie relativ zueinander. Der Kontaktrahmen wird so angeordnet, daß einerseits die inneren Anschlußenden 11 (nicht näher dargestellte) metallisierte Kontaktbereiche auf der Oberfläche des Chips und andererseits die äußeren Anschlußenden 10 die Anschlußbereiche 4 kontaktieren. Zuvor wurde hierfür entweder auf den Anschlußenden und/oder auf den metallisierten Kontaktbereichen beziehungsweise den Anschlußbereichen ein elektrisch leitendes Verbindungsmaterial (Klebstoff, Lot) aufgetragen. In einem einzigen abschließenden Verbindungsprozess können nun nach der Vorfixierung der einzelnen Bestandteile zur gleichen Zeit die elektrischen Verbindungen zwischen den äußeren Anschlußenden und den Anschlußbereichen, zwischen den inneren Anschlußenden und den metallisierten Kontaktbereichen sowie zwischen der Unterseite des Chips und der Wärmesenke hergestellt werden. Dies geschieht je nach verwendeten Verbindungsmaterialien durch Kleben (beispielsweise unter erhöhter Temperatur), Löten, Schweissen oder mittels Thermokompression. Die mit einer Linie 7 beziehungsweise 8 markierten Querschnitte werden in in der Beschreibung zu den Figuren 3 und 4 näher erläutert.

Die Verwendung eines Kontaktrahmens ermöglicht also die gleichzeitige Anbindung von oberen und unteren Anschlüssen des Halbleiterchips. Bei entsprechender Dimensionierung kann der Kontaktrahmen den Chip beim anschließenden Verbindungsprozess vor Verschiebungen schützen, indem mindestens eine Innenkante des Kontaktrahmens den Chip seitlich berührt und ihn somit seitlich fixiert.

Der Kontaktrahmen kann, wie in Figur 2 abgebildet als geschlossener Rahmen, oder auch in Form eines U, eines Winkels oder als einseitiger Streifen ausgeführt werden. Der Kontaktrahmen kann auch auf Mehrchip-Lösungen erweitert werden, d.h. der Rahmen ist dann so dimensioniert, daß mit seinen inneren Anschlußenden mehrere Chips gleichzeitig, die zuvor auf einer Unterlage vorfixiert wurden, kontaktiert werden können.

Figur 3 zeigt den in Figur 2 mit der Linie 8 markierten Querschnitt. Die Wärmesenke 2 weist Kühlrippen zur effektiven Ableitung entstehender Abwärme auf. Der Querschnitt zeigt die Anordnung nach erfolgtem Verbindungsprozess, nach dem die Verbindungsstoffschichten 20, 21 und 22 zwischen Anschlußbereich 4 und äußeren Anschlußenden 10 beziehungsweise zwischen Chip 3 und inneren Anschlußenden 11 beziehungsweise zwischen Chip 3 und Wärmesenke 2 eine mechanisch starre und elektrisch leitende Verbindung zwischen der Wärmesenke 2 und dem Chip 3 einerseits sowie zwischen dem Chip 3 und den Anschlußbereichen 4 andererseits herstellen. Die Stanzleiterbahn weist dabei eine Stufe auf, um den Höhenunterschied zwischen der Oberfläche des Chips und der Oberfläche der Anschlußbereiche 4 auszugleichen.

In einer alternativen Ausführungsform kann der Gehäuseboden auch so ausfgeführt sein, daß sich die Anschlußbereiche 4 und die Oberfläche des Chips auf gleicher Höhe befinden, so daß sich ausschließlich innerhalb einer Ebene erstreckende Stanzgitterleiterbahnen für den Kontaktrahmen verwendet werden können. In einer weiteren Alternative kann die Wärmesenke auch, ganz- oder teilflächig von Teilbereichen des Gehäusebodens unterlegt sein; dies wird insbesondere dann möglich sein, wenn die abzuführenden Wärmemengen beim Betrieb der elektrischen Baugruppe nicht so hoch sind, daß ganzflächig unterhalb der Wärmesenke ein direkter Wärmeaustausch mit der Umgebungsluft stattfinden können müßte.

Figur 4 zeigt den in Figur 2 mit der Linie 7 markierten Querschnitt. Die Wärmesenke 2 weist eine Vertiefung auf, in die ein Nasenelement 25 des Kontaktrahmens 9 hineinragt.

Dieses Nasenelement dient zur Erleichterung der Justage des Kontaktrahmens 9 relativ zum Gehäuseboden 1 beziehungsweise relativ zum auf der Wärmesenke angeordneten Halbleiterchip 3.

Das Nasenelement kann alternativ als Rastnasenelement ausgebildet sein, das in eine geeignet ausgearbeitete Vertiefung der Wärmesenke einrasten kann, sobald beim Auflegen des Kontaktrahmens auf die Wärmesenke und den Halbleiterchip dieser seine Endposition erreicht hat. Alternativ kann hierbei die Vertiefung bis zum Gehäuseboden reichen oder sogar Teile des Gehäusebodens eine Fortsetzung der Vertiefung bilden. In letzterem Falle wäre die Vertiefung besonders einfach für ein Rastnasenelement geeignet ausgestaltbar, indem die Vertiefung im Bereich des Gehäusebodens einen etwas größeren Durchmesser aufweist als im Bereich der Wärmesenke.

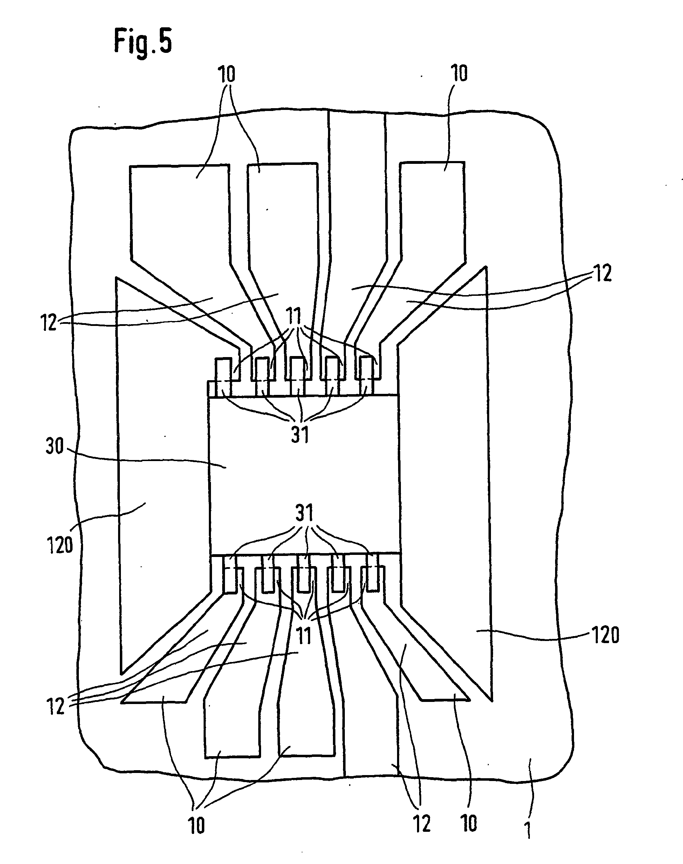

Figur 5 zeigt eine alternative Vorgehensweise, bei der ein gehäuster Halbleiterchip in Form eines SMD-Bauelements (SMD = engl. "Surface Mount Device") 30, der metallische Kontaktbeine 31 aufweist, mit Stanzgitterleiterbahnen verbunden wird. Im Gehäuseboden 1 der elektrischen Baugruppe sind hierzu Stanzgitter-Leiterbahnen 12 sowie eine Wärmesenke-Leiterbahn 120 aus Stanzgitter-Material eingebettet. Die inneren Anschlußenden 11 der Leiterbahnen sowie die sich auch unterhalb des zu kontaktierenden SMD-Bauelements 30 erstreckende Wärmesenke 120 sind so angeordnet, daß die Kontaktbeine 31 sowie die Unterseite des SMD-Bauelements paßgenau elektrisch beziehungsweise mechanisch kontaktiert werden können. Im abgebildeten Beispiel berührt die Unterseite des Bauelements die Wärmesenke 120, gleichzeitig wird diese über ein Kontaktbein mit dem Chip elektrisch kontaktiert. Die Vorfixierung des Bauelements erfolgt durch Anpressen, die dauerhafte Befestigung im Anschluß daran beispielsweise durch Laserschweissen. In einem weiteren Schritt werden offene Verbindungsstellen mit einer geeigneten elektrisch isolierenden Vergußmasse abgedeckt, um diese vor Korrosion und mechanischer Beeinflussung (Berührung beziehungsweise Beschädigung) zu schützen.

Der Teil des Stanzgitters, der für die mechanische Befestigung verwendet wird, sorgt also zugleich für die Ableitung der Abwärme des elektronischen Leistungsbauelements an die Umgebung.

In einer alternativen Ausführungsform weisen die inneren Anschlußenden der Leiterbahnen 12 ein Prägemuster auf, um ein verrutschsicheres Vorfixieren des Bauelements zu erleichtern.

Bei dem SMD-Gehäuse handelt es sich um ein Leistungs-SMD-Gehäuse, das sowohl an den seitlichen Anschlussbeinchen elektrisch kontaktiert, als auch an der metallischen Unterseite elektrisch und thermisch angeschlossen werden muss. Die Kontaktierung der Wärmesenke über ein einzelnes Kontaktbein reicht nicht aus. Beim Laserschweissen kann die Kontaktierung der SMD-Rückseite zum Beispiel auch über ein Verschweissen der Wärmesenke mit der SMD-Unterseite erfolgen, wobei die Wärmesenke geeignete Anprägungen mit definierter Dicke haben muss, damit der Laserstrahl von der Unterseite des Kühlkörpers her ein Verschmelzen zwischen Kühlkörper und SMD-Unterseite bewirken kann. Der elektrische und thermische Fluss erfolgt dann über diese Verschmelzungspunkte, die in ausreichender Zahl vorhanden sein müssen. Beim Verbinden durch Laserschweissen werden die Anschlussbeinchen von oben mit dem Laserstrahl "angeschossen", während die Verbindung SMD-Unterseite mit Kühlkörper durch einen Laserstrahl bewirkt wird, der entweder seitlich oder von unten zugeführt wird. Eine andere Ausführungsform kann auch sein, dass die metallische SMD-Unterseite über die Kunststoffumspritzung des SMD's hinausragt und es dadurch möglich ist, diese Metallunterseite in den Kühlkörper per Presspassung zu integrieren. Eventuell kann die thermische Verbindung einer solchen Presspassung durch eine wärmeleitende Paste, die zusätzlich zwischen SMD-Unterseite und Kühlkörper angebracht wird, noch unterstützt werden. Alternativ zum Laserschweissen kann auch ein Laserlöten eingesetzt werden. Auf den Kühlkörper und die Stanzgitter-Leiterbahnen muss dazu vor der Bestückung und Kontaktierung des SMD-Elements Lotpaste in den Kontaktierbereichen aufgebracht werden. Bezüglich der Laserstrahlführung gilt dann dasselbe wie beim Laserschweissen (Anschlussbeinchen von oben beschossen, SMD-Rückseite seitlich oder von unten beschossen).

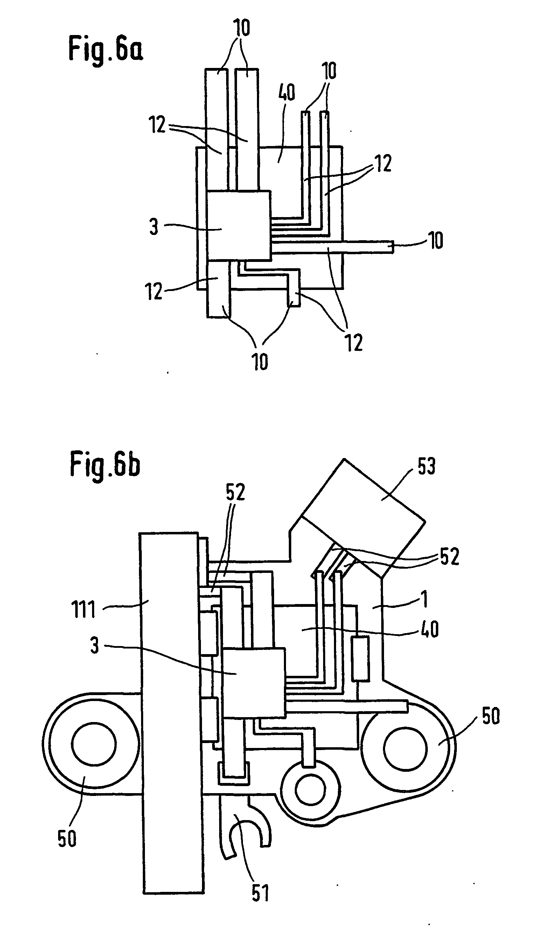

Figur 6 illustriert ein weiteres Beispiel einer Baugruppe. In Figur 6a ist ein IMS-Substrat (IMS = engl. "Insulated Metal Substrate") 40 abgebildet, aus dessen oberer Kupferschicht bereits vor dem Aufbringen des Chips 3 Metallstreifenleiterbahnen 12 herausstrukturiert worden sind. Die äußeren Anschlußenden 10 der Metallstreifenleiterbahnen überragen das Substrat. IMS-Substrate bestehen dabei aus einer dicken Kupfer- oder Aluminium-Grundplatte. Die strukturierbare Oberseite aus Kupfer ist von der Grundplatte durch eine Polymerschicht isoliert. In Figur 6a sieht man daher in den Bereichen auf diese Polymerschicht, in denen die Kupferschicht wegstrukturiert worden ist. Ist die strukturierbare Kupfer-Oberseite größer als die Grundplatte, lassen sich, nach dem Zusammenfügen von Oberseite und Grundplatte mit dazwischenliegender Polymerschicht, überragende Anschlußenden herstellen. Der Halbleiterchip wird auf dieses so vorbearbeitete IMS-Substrat in Flip-Chip-Technik aufgebracht. Hierzu wird auf dessen nicht näher dargestellten metallisierten Kontaktbereichen an seiner Unterseite Lot in Form von Kugeln (engl. "Bumps") aufgetragen und anschließend der Chip auf den inneren (in der Figur 6a durch den Chip bereits verdeckten) Anschlußenden der Metallstreifenleiterbahnen aufgelötet. In einem weiteren Schritt wird der Zwischenraum zwischen dem Chip und dem Substrat mit einem Unterfüllmaterial (engl. "Underfiller"), zum Beispiel AMICON E1252 FlipChip Underfill Encapsulant (weitere Hersteller von Underfill-Materialien sind zum Beispiel EPOTEC und Loctite), aufgefüllt, um eine thermische Anbindung zum Substrat sowie mechanische Stabilität und Korrosionsschutz insbesondere im Bereich der metallisierten Kontaktbereiche auf der Unterseite des Chips zu gewährleisten. In einem weiteren Schritt werden, falls es durch die verwendete Gehäusekonstruktion, in die nachfolgend das Substrat eingebaut werden soll, notwendig sein sollte, die überragenden äußeren Anschlußenden aufgebogen. Dies ist nicht notwendig, wenn alle Anschlußflächen in der Gehäusekonstruktion und das Substrat in einer Ebene liegen.

Falls ein strukturiertes IMS-Substrat verwendet wird, bei dem die äußeren Anschlußenden der Metallstreifenleiterbahnen nicht über das Substrat hinausragen, kann parallel oder zeitnah zur Auflötung des Chips eine Anlötung überhängender Leiter an den äußeren Anschlußenden erfolgen. Des weiteren besteht zusätzlich die Möglichkeit, SMD-Zusatzelemente auf das vorgegebene Gitter der Metallstreifenleiterbahnen aufzulöten.

Nachfolgend wird, wie in Figur 6b dargestellt, das bestückte Substrat in ein Gehäuse eingebaut. Im Ausführungsbeispiel weist das Gehäuse einen Gehäuseboden 1 und eine senkrecht zum Gehäuseboden stehende Gehäusewand 111 auf, die aus Kunststoff gefertigt sind. In das Kunststoffgehäuse sind bereits elektrisch leitende Strukturen in Form von (teilweise zum Beispiel durch das Kunststoffmaterial vollständig umgebene) Stanzgitterleiterbahnen 52 eingebracht, die nach der Montage des Substrats eine elektrische Verbindung mit einem Anschlußelement 51, metallischen Anschlußösen 50 und einem Steckerelement 53 herstellen sollen. Das Kunststoffgehäuse ist beispielsweise so konzipiert, daß das bestückte Substrat in eine passende Öffnung eingefügt und nach Erreichen der Endposition über Arretierelemente, insbesondere Klippelemente, fixiert wird. Die Stanzgitterleiterbahnen 52 beziehungsweise die Anschlußösen 50 und die Metallstreifenleiterbahnen 12 sind dabei so angeordnet, daß die das Substrat überragenden äußeren Anschlußenden der Metallstreifenleiterbahnen auf den Enden der Stanzgitterleiterbahnen beziehungsweise auf Randbereichen der metallischen Anschlußösen zu liegen kommen. Die endgültige mechanische Fixierung, die gleichzeitig eine permanente elektrische Verbindung zwischen den Metallstreifenleiterbahnen und den Stanzgitterleiterbahnen herstellt, erfolgt anschließend durch Laserschweissen. Danach wird die Anordnung passiviert, indem auf das Substrat und die kontaktierten Stanzgitterleiterbahnen des Gehäuses ein Gel aufgebracht wird. Anschließend kann das Gehäuse mit einem Deckel verschlossen werden.

Alternativ zum Laserschweissen können andere Techniken wie Löten, Laserlöten, Ultraschallschweissen oder Leitkleben zur Anwendung kommen. Lot oder Leitkleber müssen selbstverständlich vor dem Einfügen des Substrats entweder auf den Stanzgitterleiterbahnen oder den äußeren Anschlußenden der Metallstreifenleiterbahnen aufgebracht werden. In jedem Fall werden auf den Stanzgitterleiterbahnen und den sonstigen Einlegeteilen (Anschlußösen etc.) keine Oberflächen benötigt, die sich für ein Drahtbonden eignen würden, da sämtliche elektrischen Kontaktierungen über starre Metallstreifen beziehungsweise Stanzgitter erfolgen. Alternativ zum Vergelen kann zur Passivierung auch ein Vergiessen mit einer Harzmasse, ein Molden, ein Lacküberzug oder ein Aufbringen einer Glob Top- Masse durchgeführt werden, die überlicherweise zur Abdeckung eines Chips nach erfolgter Montage auf ein Substrat in Flip-Chip-Technik verwendet wird.

## Patentansprüche

1. Verfahren zur Herstellung einer elektrischen Verbindung zwischen elektrischen Anschlüssen eines Halbleiterbauelements (3) als Teil einer elektrischen Baugruppe und weiteren Teilen der elektrischen Baugruppe mittels eines innere (11) und mit den inneren über Metallstreifenleiterbahnen (12) elektrisch verbundene äußere Anschlussenden (10) aufweisenden Metallstreifengitters, wobei das Halbleiterbauelement (3) und das Metalistreifengitter so zusammengeführt werden, dass **dadurch** eine Positionierung von mindestens zwei elektrischen Anschlüssen des Halbleiterbauelements (3) auf korrespondierenden inneren Anschlussenden (11) erfolgt, so dass eine unverrückbare Befestigung des Halbleiterbauelement (3) an den zwei inneren Anschlussenden (11) erhalten wird, wobei diese mechanische Befestigung gleichzeitig eine elektrische Verbindung zwischen den elektrischen Anschlüssen des Halbleiterbauelements (3)und den inneren Anschlussenden (11) herstellt, wobei als Metallstreifengitter (4) ein bereits vor der Zusammenführung mit dem Halbleiterbauelement (3) zumindest auf einer Seite zumindest in einem Teilbereich mit einem elektrisch nicht leitfähigen Material (9) verbundenes Metallstreifengitter verwendet wird und das elektrisch nicht leitfähige Material (9) einen Kontaktrahmen bildet, der die mechanische Verbindung und Fixierung der die Leiterbahnen bildenden wenigstens zwei Metallstreifenleiterbahnen relativ zueinander bewirkt, **dadurch gekennzeichnet, dass** bei der Befestigung gleichzeitig der Halbleiterchip (3) fixiert wird, wobei dieser durch die Innenkante des nicht leitfähigen Materials vor einem Verrutschen geschützt wird.

2. Verfahren nach Anspruch 1, **dadurch gekennzeichnet, dass** als Halbleiterbauelement ein ungehäuster Halbleiterchip (3) verwendet wird, dessen elektrische Anschlüsse durch metallisierte Kontaktbereiche gebildet sind.

3. Verfahren nach Anspruch 2, **dadurch gekennzeichnet, dass** als Metallstreifengitter ein zumindest in einem Teil des Teilbereichs beidseitig von elektrisch nicht leitfähigem Material umgebenes Stanzgitter verwendet wird.

4. Verfahren nach Anspruch 3, **dadurch gekennzeichnet, dass** der Teilbereich die Form eines geschlossenen Rahmens (9) oder eines Winkels aufweist.

5. Verfahren nach einem der Ansprüche 2 bis 4, **dadurch gekennzeichnet, dass** in einem elektrisch nicht-leitenden Gehäuse (1) zunächst ein als Wärmesenke dienender metallischer Körper (2) eingebracht wird, dass in einem weiteren Schritt das Halbleiterbauelement (3) auf seiner Unterseite mit einem elektrisch leitfähigen Verbindungsstoff belegt wird, dass anschließend das Halbleiterbauelement auf dem metallischen Körper (2) angeordnet wird, dass in einem weiteren Schritt die elektrischen Anschlüsse auf der Oberseite des Halbleiterbauelements oder die inneren Anschlussenden (11) des Stanzgitters mit dem gleichen oder einem weiteren elektrisch leitfähigen Verbindungsstoff belegt werden, dass daraufhin die Positionierung erfolgt, wobei gleichzeitig das Stanzgitter mit seinen äußeren Anschlussenden (10) auf Anschlussbereichen (4, 4a) der weiteren Teile der elektrischen Baugruppe zu liegen kommt, und dass in einem weiteren Schritt die Befestigung erfolgt, wobei gleichzeitig eine Befestigung der äußeren Anschlussenden an den Anschlussbereichen erfolgt.

6. Verfahren nach Anspruch 5, **dadurch gekennzeichnet, dass** das Stanzgitter zur Justierung vorfixiert wird, indem ein am Metallstreifengitter aus elektrisch nicht-leitfähigem Material angebrachtes Nasenelement (25) in eine auf der Wärmesenke vorhandene Öffnung (6) eingreift.

7. Verfahren nach Anspruch 6, **dadurch gekennzeichnet, dass** das Nasenelement (25) in die Öffnung einrastet.

## Claims

1. Method for production of an electrical connection between electrical connections of a semiconductor component (3) as part of an electrical assembly and further parts of the electrical assembly by means of a metal strip grid which has inner connecting ends (11) and outer connecting ends (10) which are electrically connected to the inner connecting ends (11) via metal strip conductor tracks (12), wherein the semiconductor component (3) and the metal strip grid are joined together such that they result in positioning of at least two electrical connections of the semiconductor component (3) on corresponding inner connecting ends (11) thus resulting in irreversible attachment of the semiconductor component (3) to the two inner connecting ends (11), wherein this mechanical attachment at the same time produces an electrical connection between the electrical connections of the semiconductor component (3) and the inner connecting ends (11), wherein a metal strip grid, which is already connected to an electrically non-conductive material (9) at least on one side and at least in one subarea before being joined to the semiconductor component (3), is used as the metal strip grid (4), and the electrically non-conductive material (9) forms a contact frame which results in the mechanical connection and fixing of the at least two metal strip conductor tracks which form the conductor tracks, relative to one another, **characterized in that** the semiconductor chip (3) is fixed at the same time during the attachment process, and is protected against sliding by the inner edge of the non-conductive material.

2. Method according to Claim 1, **characterized in that** an unpackaged semiconductor chip (3) is used as the semiconductor component, and its electrical connections are formed by metallized contact areas.

3. Method according to Claim 2, **characterized in that** a stamped grid, which is surrounded on both sides by electrically non-conductive material, at least in a part of the subarea, is used as the metal strip grid.

4. Method according to Claim 3, **characterized in that** the subarea is in the form of a closed frame (9) or an angle.

5. Method according to one of Claims 2 to 4, **characterized in that** a metallic body (2) which is used as a heat sink is first of all introduced in an electrically non-conductive package (1), **in that**, in a further step, the semiconductor component (3) has an electrically conductive connecting substance applied to its lower face, **in that** the semiconductor component is then arranged on the metallic body (2), **in that**, in a further step, the electrical connections on the upper face of the semiconductor component or the inner connecting ends (11) of the stamped grid have the same or a further electrically conductive connecting substance applied to them, **in that** the positioning is then carried out, with the stamped grid at the same time coming to rest with its outer connecting ends (10) on connecting areas (4, 4a) of the further parts of the electrical assembly, and **in that**, in a further step, the attachment process is carried out, wherein the outer connecting ends are attached to the connecting areas at the same time.

6. Method according to Claim 5, **characterized in that** the stamped grid is preliminarily fixed for adjustment in that a tab element (25), which is fitted to the metal strip grid composed of electrically non-conductive material, engages in an opening (6) which is provided on the heat sink.

7. Method according to Claim 6, **characterized in that** the tab element (25) latches into the opening.

## Revendications

1. Procédé pour établir une liaison électrique entre des bornes de raccordement électrique d'un composant semi-conducteur (3) qui fait partie d'un module électrique et d'autres parties du module électrique au moyen d'une grille intérieure de rubans métalliques qui présente des extrémités intérieures (11) de bornes de raccordement et des extrémités extérieures (10) de bornes de raccordement reliées électriquement aux extrémités intérieures de bornes de raccordement par des pistes conductrices (12) en rubans métalliques,
le composant semi-conducteur (3) et la grille de rubans métalliques étant assemblés de manière à positionner au moins deux bornes de raccordement électriques du composant semi-conducteur (3) sur des extrémités intérieures correspondantes (11) des bornes de raccordement pour fixer de manière inamovible le composant semi-conducteur (3) sur les deux extrémités intérieures (11) des bornes de raccordement,
cette fixation mécanique établissant en même temps une liaison électrique entre les bornes de raccordement électrique du composant semi-conducteur (3) et les extrémités intérieures (11) des bornes de raccordement,
tandis que pour la grille (4) de rubans métalliques, on utilise une grille de rubans métalliques reliée dès avant l'assemblage à l'élément semi-conducteur (3) à un matériau électriquement non conducteur (9) au moins sur une partie d'un côté, le matériau électriquement non conducteur (9) formant un encadrement de contact qui a pour effet la liaison mécanique mutuelle et la fixation des deux ou plusieurs pistes conductrices en rubans métalliques qui forment les pistes conductrices,
**caractérisé en ce que**
la puce semi-conductrice (3) est immobilisée en même temps que la fixation et est ainsi empêchée de se déplacer par les bords intérieurs du matériau non conducteur.

2. Procédé selon la revendication 1, **caractérisé en ce que** comme composant semi-conducteur, on utilise une puce semi-conductrice (3) sans boîtier dont les bornes de raccordement électriques sont formées par des parties métallisées de contact.

3. Procédé selon la revendication 2, **caractérisé en ce que** comme grille de rubans métalliques, on utilise au moins une grille estampée dans une partie de la partie entourée des deux côtés par le matériau électriquement non conducteur.

4. Procédé selon la revendication 3, **caractérisé en ce que** la partie présente la forme d'un encadrement fermé (9) ou d'un coude.

5. Procédé selon l'une des revendications 2 à 4, **caractérisé en ce qu'**un corps métallique (2) qui sert de drain de chaleur est d'abord placé dans un boîtier (1) électriquement non conducteur, **en ce que** dans une autre étape, le côté inférieur de l'élément semi-conducteur (3) est recouvert d'un matériau de liaison électriquement conducteur, **en ce que** l'élément semi-conducteur est ensuite placé sur le corps métallique (2), **en ce que** dans une autre étape, les bornes de raccordement électriques situées sur le côté supérieur du composant semi-conducteur ou les extrémités intérieures (11) des bornes de raccordement de la grille estampée sont recouvertes par un même matériau de liaison électriquement conducteur ou par des matériaux de liaison électriquement conducteurs différents, **en ce que** l'on réalise ensuite le positionnement par lequel la grille estampée vient en même temps se placer par ses extrémités extérieures (10) de bornes de raccordement sur des parties (4, 4a) de bornes de raccordement des autres parties du module électrique et **en ce que** dans une autre étape, on effectue la fixation au cours de laquelle on réalise en même temps une fixation des extrémités extérieures des bornes de raccordement sur les parties de bornes de raccordement.

6. Procédé selon la revendication 5, **caractérisé en ce que** la grille estampée est pré-fixée pour être ajustée en engageant un élément de bec (25) placé sur la grille de rubans métalliques et en matériau électriquement non conducteur dans une ouverture (6) prévue sur le drain thermique.

7. Procédé selon la revendication 6, **caractérisé en ce que** l'élément en bec (25) s'encliquette dans l'ouverture.
